# EUROPEAN PATENT SPECIFICATION

(11) **EP 2 584 879 B1**
(45) Date of publication and mention of the grant of the patent: **19.12.2018**
(21) Application number: 12188743.4
(22) Date of filing: 16.10.2012
(51) Int. Cl.: H05K 7/20

(54) **High temperature environment capable motor controller**
Umgebungsfähiges Hochtemperatur-Motorsteuergerät
Contrôleur de moteur dans un environnement de température élevée

(30) Priority: 18.10.2011 US 201113275914
(43) Date of publication of application: 24.04.2013
(73) Proprietor: Hamilton Sundstrand Corporation, Windsor Locks, CT 06096-1010 (US)
(72) Inventor: Kokas, Jay W., East Granby, CT Connecticut 06026 (US); Versailles, Richard E., New Hartford, CT Connecticut 06057 (US); Klapatch, Robert D., Wethersfield, CT Connecticut 06109 (US); Maynard, Michael, Springfield, MA Massachusetts 01118 (US); Querns, Kerry R., Durham, CT Connecticut 06422 (US)
(74) Representative: Dehns

(56) References cited:
- WO-A1-2008/031638
- US-A1- 2001 012 212

## Description

### STATEMENT OF GOVERNMENT INTEREST

This invention was made with government support under Contract No. FA8650-06-D-2621, awarded by the United States Air Force. The government has certain rights in the invention.

### BACKGROUND

The present invention relates generally to electronics cooling, and more particularly to motor controllers designed to operate in a high temperature environment. Many aircraft engines have historically used fueldraulic actuation systems located in very hot engine areas. Such fueldraulic actuators add to fuel system heating during engine operation. Heat is generated during fuel pumping to support fueldraulic actuation and fueldraulic actuator cooling. The amount of heat generated in this way limits the extent to which fuel can be used as a coolant fluid to cool other engine components.

As an alternative to fueldraulic actuation, some recent designs simplify fuel routing and avoid cooling problems by utilizing purely electric actuation systems. A typical electric actuation system comprises an actuator, a motor, and an electronic motor controller. Actuators must be situated in hot engine environments, while motor controller electronics are sensitive to heat, and rapidly degrade if not adequately cooled. As a result, motor controllers for aircraft engine actuation systems have conventionally been situated at locations remote from the hot engine environment of the actuators, and connected to actuators via long cable harnesses. These long cable harnesses increases the overall weight of the actuation system, and can create electromagnetic interference issues caused by fast switching of motor drive signals over long cable lengths.

US 2001/012212 and WO 2008/031638 teach cooling systems.

### SUMMARY

The present invention is directed toward a motor controller for use in an environment at a high environmental temperature. The motor controller comprises an insulated chassis, a high-temperature capable electronic component, a low-temperature capable electronic component, and a heat pump. The chassis has a finned surface which dissipates heat into the environment of the motor controller. The high-temperature capable electronic component is rated for a temperature higher than the maximum environmental temperature, while the low-temperature electronic component is rated for a temperature lower than the maximum environmental temperature. The low-temperature capable electronic component is attached to or integrated into a printed wiring board supported inside the insulated chassis by a plurality of thermally conductive posts. The heat pump draws heat from low-temperature capable electronic component through these conductive posts and a thermal spreader abutting the heat pump, and expels heat into the finned surface of the enclosed insulating chassis. The high-temperature capable electronic component is mounted inside the insulated chassis on the finned surface, or connected to the finned surface for passive cooling by the thermally conductive posts.

### BRIEF DESCRIPTION OF THE DRAWINGS

FIG. 1 is an exploded view of a motor controller for use in a high temperature environment.
FIG. 2 is a cross-sectional view of the motor controller of FIG. 1 in an assembled state.

### DETAILED DESCRIPTION

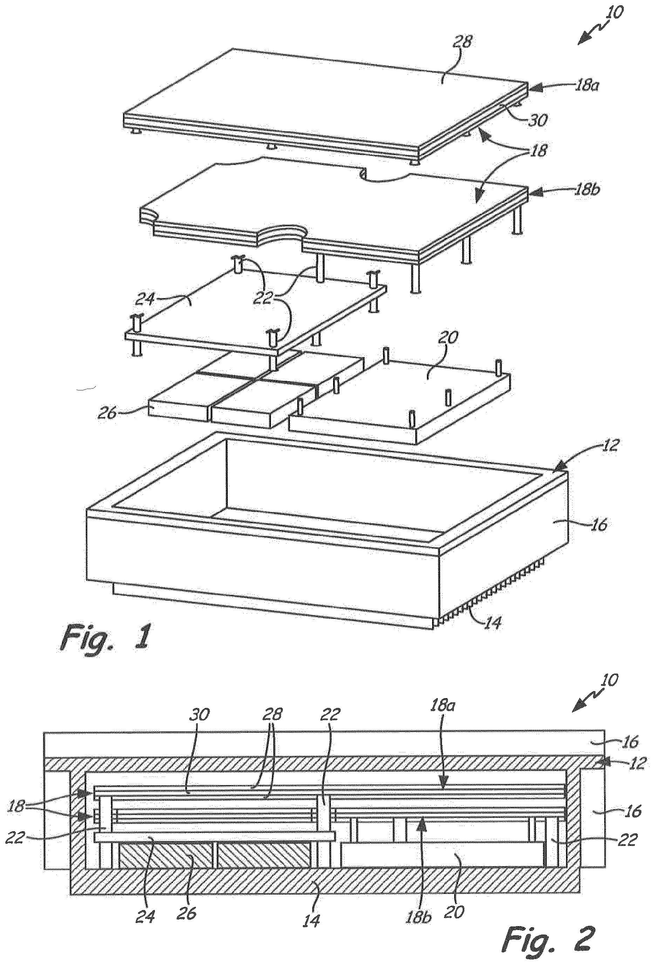

FIGs. 1 and 2 depict motor controller 10, comprising chassis 12 with finned surface 14 and insulation 16. Chassis 12 encloses printed wiring board (PWB) modules 18 (including low-temperature capable PWB module 18a and high-temperature capable PWB module 18b), field effect transistor (FET) module 20, thermally conductive posts 22, thermal spreader 24, and heat pump 26. PWB modules 18 comprise two PWBs 28 mounted on a single heatsink substrate 30, such that each heatsink substrate 30 is sandwiched between two PWBs 28. FIG. 1 is an exploded view of motor controller 10, while FIG. 2 is a cross-sectional view of motor-controller 10 in an assembled state.

Chassis 12 is a rigid structure which contains, supports, and protects PWB modules 18 and FET module 20 in a hot environment such as near or on an aircraft engine. In some embodiments (not shown), chassis 12 may feature a separable cover. Chassis 12 has insulation 16 which shields PWB modules 18 and FET module 20 from environmental and radiated heat. Some environments may, for instance, routinely reach temperatures of ∼200°C, while engine surface temperatures may exceed 300°C. Insulation 16 is a separate insulating layer which may be formed of any conventional solid insulator suitable for environmental temperatures, and which substantially surrounds all of chassis 12 except finned surface 14, which is not covered. Insulation 16 may, for instance, comprise a series of insulating layers attached to the structure chassis 12. Alternatively, insulation 16 may comprise an insulating sheath or receptacle for chassis 12. Chassis 12 may, for instance, be an aluminum enclosure which protects interior components from fluids, particulates, and excessive heat. Chassis 12 includes a finned surface 14, a thermally conductive base which provides a flat platform for components such as heat pump 26 and FET module 20, and which has a plurality of cooling fins which provide increased surface area for dissipating heat into the environment. Finned surface 14 may, in some embodiments, extend into an environmental air flow for increased heat dissipation.

PWBs 28 may include a variety of attached or integrated electronic elements such as processors, memory, resistors, and capacitors, which may be rated to temperatures lower than the maximum temperature of the environment (i.e. ∼200 °C), or higher (i.e. ∼250+ °C). In the depicted embodiment, PWBs 28 rated only for temperatures lower than the maximum temperature of the environment are mounted on low-temperature capable PWB module 18a, while components rated for higher temperatures are mounted on high-temperature capable PWB module 18b. FET module 20 is an electronic hybrid module containing a number of metal oxide field effect transistors (MOSFETs) or equivalent components rated to a sufficiently high temperature so as to not require active cooling within the hot environment (i.e. ∼250+°C). PWBs 28 and FET module 20 produce heat during operation, and must be kept at or below rated temperatures to avoid damage and maximize component lifetimes. To this end, heat is dissipated from PWBs 28 and FET module 20 into the environment via finned surface 14 of chassis 12. Motor controller 10 provides at least two separate heat paths to dissipate heat from PWBs 28 and FET module 20. High temperature capable components such as FET module 20 and high-temperature capable PWB module 18b can be cooled passively, and are mounted on finned surface either directly, or via thermally conductive posts 22. Components rated only for temperatures lower than the maximum temperature of the environment, such as PWBs 28 on low-temperature capable PWB module 18a, are actively cooled using heat pump 26 to force heat from PWBs 28 to finned surface 14 of chassis 12.

PWB modules 18 are supported by posts 22, which are rigid structural supports with high thermal conductivity. Posts 22 may, for instance, be aluminum rods. Within each PWB module 18, heatsink substrate 30 conducts heat from PWBs 28 to posts 22, which conduct heat to either thermal spreader 24 or finned surface 14 of chassis 12. Although all PWBs 28 depicted in FIGs. 1 and 2 are part of PWB modules 18, alternative embodiments of motor controller 10 may include isolated PWBs 28 which are directly attached to chassis 12, posts 22, or thermal spreader 24. As shown, some posts 22 may connect PWB modules 18 directly to finned surface 14, while at least some posts 22 provide a thermal path from PWB modules 18 to thermal spreader 24. In particular, posts 22 connect high-temperature capable PWB module 18b to chassis 14 or FET module 20 for passive cooling, while posts 22 connect low-temperature capable PWB module 18a to thermal spreader 24 for active cooling. Some posts 22 may be positioned at or near high-heat locations of PWB modules 18. Posts 22 support PWB modules 18 such that each PWB module 18 is separated from adjacent components by an air gap. Low-temperature and high-temperature capable components are at least partially thermally isolated to minimize heat flow from high-temperature capable components to lower-temperature capable components. Although two stacked PWB modules 18 are shown in FIGs. 1 and 2, motor controller 10 may alternatively be constructed with one PWB module 18, or with three or more stacked PWB modules 18, any number of which may require active cooling (such as low-temperature capable PWB module 18a, in the depicted embodiment). The stacking of PWB modules 18 is limited by the ability of posts 22 to serve as thermal conduits between PWB modules 18 and chassis 14 or thermal spreader 24.

Heat pump 26 draws heat from PWBs 28 in low-temperature capable PWB module 18a through heatsink substrate 30, posts 22, and thermal spreader 24, and expels heat into finned surface 14 of chassis 12. Thermal spreader 24 directly abuts heat pump 26, as best seen in FIG. 2. Thermal spreader 24 is a cold heat plate which distributes heat from posts 22 evenly across heat pump 26. In some embodiments thermal spreader 24 includes embedded heat pipes which disperse heat across thermal spreader 24 by capillary wicking. In other embodiments thermal spreader 24 is a solid plate or block of conductive material, such as aluminum. Heat pump 26 actively forces heat from thermal spreader 24 to finned surface 14. Heat pump 26 may, for instance, be a conventional thermoelectric cooler. Heat pump 26 cools low-temperature rated components on PWB 28 to under rated temperatures. In some embodiments, thermal interfaces in the form of thermal pads, films, or layers may be inserted between adjacent components in the two heat flow paths described above, to improve thermal conductivity.

By selecting electronic components (PWB 18 and FET module 20) with high rated temperatures, and by actively cooling components rated for lower temperatures with a heat pump, as described above, motor controller 10 is able to operate in high temperature environments such as on or near an aircraft engine. Accordingly, motor controller 10 may be located adjacent a connected engine actuator in a hot engine location as a part of an aircraft engine actuation system. This improvement allows the conventional long, heavy cable harness between actuator and motor controller to be dispensed with, reducing the overall weight of the actuation system, and minimizing electromagnetic interference issues from cable length.

While the invention has been described with reference to an exemplary embodiment(s), it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment(s) disclosed, but that the invention will include all embodiments falling within the scope of the appended claims.

## Claims

1. A motor controller for use in an environment at a high maximum environmental temperature, the motor controller comprising:
an enclosed insulated chassis (12) with a finned surface (14); and **characterised by**
a high-temperature capable electronic component rated for a temperature higher than the maximum environmental temperature, and mounted inside the insulated chassis, on the finned surface or connected to the finned surface by at least some of a plurality of thermally conductive posts;
a low-temperature capable electronic component rated for a temperature lower than the maximum environmental temperature, attached to or integrated into a printed wiring board (18) supported inside the insulated chassis by at least some of a plurality of thermally conductive posts;
a heat pump (26) configured to draw heat from the low-temperature capable electronic component through the plurality of thermally conductive posts and a thermal spreader (24) abutting the heat pump, and to expel heat into the finned surface of the enclosed insulating chassis.

2. The motor controller of claim 1, wherein the thermal spreader includes a plurality of heat pipes which distribute heat substantially evenly across the thermal spreader by capillary wicking, or wherein the thermal spreader is a solid plate or block of material with high thermal conductivity.

3. The motor controller of claim 1, wherein the high-temperature capable electronic component is a field effect transistor module (20), or wherein the high-temperature capable electronic component includes printed wiring board components attached to or integrated into a printed wiring board supported inside the insulated chassis by thermally conductive posts (22).

4. The motor controller of claim 1, wherein the heat pump is a thermoelectric cooler.

5. The motor controller of claim 1, wherein at least some of the thermally conductive posts are positioned near high heat locations on the printed wiring board.

6. The motor controller of claim 1, wherein the printed wiring board is mounted on a heatsink substrate (30) in thermal contact with the thermally conductive posts.

7. The motor controller of claim 6, further comprising another printed wiring board mounted on the heatsink plate, such that the heatsink substrate is sandwiched between the printed wiring boards.

8. A method of cooling motor controller components in an environment at a high maximum environmental temperature, the method comprising:
enclosing in a chassis with a finned surface:
a first electronic component rated at a first rating temperature significantly higher than the maximum environmental temperature; and
a second electronic component rated at a second rating temperature lower than the maximum environmental temperature;
passively dissipating heat from the first electronic component by mounting the first electronic component on the finned surface; and
actively drawing heat from the second electronic component with a heat pump via a plurality of thermally conductive posts and a thermal spreader, and expelling heat from the heat pump into the finned surface.

9. The method of claim 8, further comprising spreading heat from the thermally conductive posts across the heat pump via heat pipes in the thermal spreader.

10. The method of claim 8, further comprising insulating the chassis from the environment, except at the finned surface.

## Patentansprüche

1. Motorsteuergerät zur Verwendung in einer Umgebung bei einer maximalen Umgebungshochtemperatur, wobei das Motorsteuergerät Folgendes umfasst:
ein umschlossenes isoliertes Gehäuse (12) mit einer gerippten Oberfläche (14); und **gekennzeichnet durch**
ein hochtemperaturfähiges elektronisches Bauteil, das für Temperaturen ausgelegt ist, die höher als die maximale Umgebungstemperatur sind, und das innerhalb des isolierten Gehäuses auf der gerippten Oberfläche befestigt oder mit der gerippten Oberfläche durch wenigstens einige von einer Vielzahl von thermisch leitenden Pfählen verbunden ist;
ein niedrigtemperaturfähiges elektronisches Bauteil, das für eine Temperatur ausgelegt ist, die geringer als die maximale Umgebungstemperatur ist, und das an einer gedruckten Leiterplatte (18) befestigt oder darin integriert ist, die innerhalb des isolierten Gehäuses von wenigstens einigen von einer Vielzahl von thermisch leitenden Pfählen gestützt wird;
eine Wärmepumpe (26), die dazu konfiguriert ist, durch die Vielzahl von thermisch leitenden Pfählen und einen thermischen Verteiler (24), der an die Wärmepumpe stößt, Wärme von dem niedrigtemperaturfähigen elektronischen Bauteil abzuziehen und Wärme in die gerippte Oberfläche des umschlossenen isolierenden Gehäuses auszustoßen.

2. Motorsteuergerät nach Anspruch 1, wobei der thermische Verteiler eine Vielzahl von Wärmerohren einschließt, die über Kapillarkanäle Wärme im Wesentlichen gleichmäßig über den thermischen Verteiler verbreiten, oder wobei der thermische Verteiler eine solide Platte oder ein solider Block eines Materials mit hoher Wärmeleitfähigkeit ist.

3. Motorsteuergerät nach Anspruch 1, wobei das hochtemperaturfähige elektronische Bauteil ein Feldeffektsendermodul (20) ist, oder wobei das hochtemperaturfähige elektronische Bauteil gedruckte Leiterplattenbauteile einschließt, die an einer gedruckten Leiterplatte, die innerhalb des isolierten Gehäuses von thermisch leitenden Pfählen (22) gestützt wird, befestigt oder darin integriert sind.

4. Motorsteuergerät nach Anspruch 1, wobei die Wärmepumpe ein thermoelektrischer Kühler ist.

5. Motorsteuergerät nach Anspruch 1, wobei wenigstens einige der thermisch leitenden Pfähle in der Nähe von Positionen großer Wärme auf der gedruckten Leiterplatte positioniert sind.

6. Motorsteuergerät nach Anspruch 1, wobei die gedruckte Leiterplatte auf einem Wärmesenkensubstrat (30) angebracht ist, das in thermischem Kontakt mit den thermisch leitenden Pfählen ist.

7. Motorsteuergerät nach Anspruch 6, ferner umfassend eine weitere gedruckte Leiterplatte, die auf der Wärmesenkenplatte so angebracht ist, dass das Wärmesenkensubstrat zwischen den gedruckten Leiterplatten eingebettet ist.

8. Verfahren zum Kühlen von Motorsteuergerätebauteilen in einer Umgebung bei einer maximalen Umgebungshochtemperatur, wobei das Verfahren Folgendes umfasst:
Umschließen von Folgendem in einem Gehäuse mit einer gerippten Oberfläche:
eines ersten elektronischen Bauteils, das auf eine erste Nenntemperatur ausgelegt ist, die wesentlich höher als die maximale Umgebungstemperatur ist; und
eines zweiten elektronischen Bauteils, das auf eine zweite Nenntemperatur ausgelegt ist, die geringer als die maximale Umgebungstemperatur ist;
passives Ableiten von Wärme von dem ersten elektronischen Bauteil durch das Befestigen des ersten elektronischen Bauteils auf der gerippten Oberfläche; und
aktives Abziehen von Wärme von dem zweiten elektronischen Bauteil mit einer Wärmepumpe über eine Vielzahl von thermisch leitenden Pfählen und einen thermischen Verteiler, und Ausstoßen von Wärme von der Wärmepumpe in die gerippte Oberfläche.

9. Verfahren nach Anspruch 8, ferner umfassend das Verteilen von Wärme von den thermisch leitenden Pfählen über die Wärmepumpe durch Wärmerohre in dem thermischen Verteiler.

10. Verfahren nach Anspruch 8, ferner umfassend das Isolieren des Gehäuses gegenüber der Umgebung, mit Ausnahme an der gerippten Oberfläche.

## Revendications

1. Dispositif de commande de moteur destiné à être utilisé dans un environnement à une température environnementale maximale élevée, le dispositif de commande de moteur comprenant :
un châssis isolé confiné (12) avec une surface à ailettes (14) ; et **caractérisé par**
un composant électronique apte à fonctionner à température élevée conçu pour une température supérieure à la température environnementale maximale, et monté à l'intérieur du châssis isolé, sur la surface à ailettes ou relié à la surface à ailettes par au moins quelques-uns d'une pluralité de montants thermoconducteurs ;
un composant électronique apte à fonctionner à basse température conçu pour une température inférieure à la température environnementale maximale, fixé à ou intégré dans une carte de circuit imprimé (18) supportée à l'intérieur du châssis isolé par au moins quelques-uns d'une pluralité de montants thermoconducteurs ;
une pompe à chaleur (26) configurée pour aspirer de la chaleur à partir du composant électronique apte à fonctionner à basse température par l'intermédiaire de la pluralité de montants thermoconducteurs et d'un dissipateur thermique (24) butant contre la pompe à chaleur, et expulser la chaleur à l'intérieur de la surface à ailettes du châssis isolant confiné.

2. Dispositif de commande de moteur selon la revendication 1, dans lequel le dissipateur thermique comprend une pluralité de caloducs qui distribuent la chaleur de manière sensiblement uniforme à travers le dissipateur thermique par évacuation capillaire, ou dans lequel le dissipateur thermique est une plaque ou un bloc massif de matériau à haute conductivité thermique.

3. Dispositif de commande de moteur selon la revendication 1, dans lequel le composant électronique apte à fonctionner à température élevée est un module de transistors à effet de champ (20), ou dans lequel le composant électronique apte à fonctionner à température élevée comprend des composants de carte de circuit imprimé fixés à ou intégrés dans une carte de circuit imprimé supportée à l'intérieur du châssis isolé par des montants thermoconducteurs (22).

4. Dispositif de commande de moteur selon la revendication 1, dans lequel la pompe à chaleur est un refroidisseur thermoélectrique.

5. Dispositif de commande de moteur selon la revendication 1, dans lequel au moins certains des montants thermoconducteurs sont positionnés à proximité d'emplacements à chaleur élevée sur la carte de circuit imprimé.

6. Dispositif de commande de moteur selon la revendication 1, dans lequel la carte de circuit imprimé est montée sur un substrat de dissipation thermique (30) en contact thermique avec les montants thermoconducteurs.

7. Dispositif de commande de moteur selon la revendication 6, comprenant en outre une autre carte de circuit imprimé montée sur la plaque de dissipation thermique, de telle sorte que le substrat de dissipation thermique est pris en sandwich entre les cartes de circuit imprimé.

8. Procédé de refroidissement de composants de dispositif de commande de moteur dans un environnement à température environnementale maximale élevée, le procédé comprenant :
le confinement dans un châssis avec une surface à ailettes :
d'un premier composant électronique ayant une première température de consigne significativement supérieure à la température environnementale maximale ; et
d'un second composant électronique ayant une seconde température de consigne inférieure à la température environnementale maximale ;
la dissipation de chaleur passive à partir du premier composant électronique par le montage du premier composant électronique sur la surface à ailettes ; et
la dissipation de chaleur active à partir du second composant électronique au moyen d'une pompe à chaleur par l'intermédiaire d'une pluralité de montants thermoconducteurs et d'un dissipateur de chaleur, et
l'expulsion de chaleur à partir de la pompe à chaleur à l'intérieur de la surface à ailettes.

9. Procédé selon la revendication 8, comprenant en outre la dissipation de chaleur à partir des montants thermoconducteurs à travers la pompe à chaleur par l'intermédiaire de caloducs dans le dissipateur thermique.

10. Procédé selon la revendication 8, comprenant en outre l'isolation du châssis par rapport à l'environnement, à l'exception de la surface à ailettes.
